# FASCICULE DE BREVET EUROPEEN

(11) **EP 0 612 943 B1**
(45) Date de publication et mention de la délivrance du brevet: **16.04.1997**
(21) Numéro de dépôt: 94400378.9
(22) Date de dépôt: 22.02.1994
(51) Int. Cl.: F16K 37/00, H03K 17/95, G01D 5/20

(54) **Dispositif de contrôle inductif pour tête de soupape**
Induktive Überwachungseinrichtung für Ventilklappe
Inductive monitoring device for valve member

(30) Priorité: 23.02.1993 US 21376
(43) Date de publication de la demande: 31.08.1994
(73) Titulaire: FRAMATOME, 92084 Paris-la-Défense (FR)
(72) Inventeur: Glass III, Samuel W., Lynchburg, Virginia 24503 (US); Rossman, Timothy A., Lynchburg, Virginia 24502 (US); Ataman, Vedat T., Lynchburg, Virginia 24501 (US)
(74) Mandataire: Armengaud Ainé, Alain

(56) Documents cités:
- EP-A- 0 316 914
- WO-A-89/05938
- DE-A- 3 312 756
- GB-A- 2 095 407
- US-A- 4 133 511
- US-A- 4 244 108
- US-A- 4 526 177
- US-A- 4 777 979
- US-A- 5 086 273
- REVUE DE PHYSIQUE APPLIQUEE, vol.25, no.7, Juillet 1990, PARIS FR pages 721 - 735 D. PLACKO ET AL 'Modélisation de capteurs inductifs pour la mesure à travers une paroi métallique amagnétique'

## Description

La présente invention se rapporte de façon générale au contrôle des soupapes d'arrêt et en particulier à un système et à un procédé nouveaux et efficaces de contrôle d'une soupape d'arrêt par détection inductive de son mouvement.

Maintenir la fiabilité d'utilisation des soupapes d'arrêt dans des centrales électriques et autres industries mettant en oeuvre des soupapes de ce genre dont le rôle est particulièrement important, demande un contrôle périodique pour s'assurer que ces soupapes fonctionnent de façon correcte.

Une méthode peut consister dans un démontage de la soupape d'arrêt et dans un examen visuel et un contrôle de toutes ses pièces pour détecter une usure potentielle et prévenir des accidents de toute sorte. Notamment si on constate que certaines pièces sont détériorées ou défectueuses, celles-ci peuvent être remplacées avant que la soupape ne soit remontée et remise en exploitation. Selon cette méthode toutefois, il est courant d'assembler une soupape qui apparaît en bon état après démontage et contrôle, et qui ensuite se révèle inefficace après remontage et retour en exploitation.

Un procédé également efficace mais plus coûteux pour contrôler de telles soupapes consiste à vérifier le fonctionnement de celles-ci, sans avoir à les démonter.

Dans ce cas, divers aspects sont à prendre en considération pour effectuer la vérification fonctionnelle de chaque appareil, parmi lesquels figure principalement le contrôle du déplacement de la tête de soupape, en général en forme de disque.

Une technique pour vérifier le déplacement de la tête de la soupape consiste à utiliser un transducteur ultrasonique, afin d'émettre une impulsion acoustique à travers l'enceinte ou boîtier de cette soupape pour obtenir une réflexion sur cette tête. Puisque celle-ci se déplace avec la soupape, la distance que parcourt l'impulsion acoustique entre l'enceinte et la tête varie. Du fait de cette variation, le temps de retard entre l'impulsion initiale issue du transducteur ultrasonique et la réflexion reçue en provenance de la tête de la soupape est modifiée. Ce problème demande que la soupape soit totalement ou au moins partiellement remplie avec de l'eau ou un autre milieu conducteur du son, de manière à réaliser un contrôle adéquat. Ce procédé, utilisant un transducteur ultrasonique, ne peut cependant pas être utilisé pour des soupapes d'arrêt qui sont remplies d'air ou de gaz.

Des procédés électromagnétiques ont également été utilisés afin d'examiner et de contrôler des soupapes d'arrêt sans remplissage d'eau ou de fluide conducteur du son, en particulier sur des soupapes qui, par ailleurs, ne supportent pas une détection acoustique du déplacement de leur tête. Si celle-ci est faite d'un acier au carbone ou d'un matériau ferromagnétique, il est possible de placer un aimant à courant continu développant une force convenable sur un côté de la soupape et de détecter, sur l'autre côté de cette dernière, des fluctuations résultant du passage de la tête de la soupape à travers le champ magnétique créé, en utilisant des capteurs à effet Hall.

Ce procédé a été testé avec succès pour des enceintes de soupape constituées d'un matériau ferromagnétique, ayant une tête également formée d'une tel matériau. Une certaine sensibilité est toutefois également possible avec des matériaux pour tête de soupape non ferromagnétiques.

Une autre approche, conforme an préambule de la revendication 1 et illustrée par l'US-A-5 086 273, pour le contrôle de soupapes d'arrêt consiste à utiliser une paire ou une série de bobines, situées soit sur les côtés opposés à l'extérieur de l'enceinte de la soupape, soit très près l'une de l'autre. Cet agencement de bobines cependant, doit assurer que les champs de ces bobines sont influencés par la position de la tête de la soupape. Une des bobines sur l'enceinte de celle-ci est excitée par un courant alternatif ou sinusoïdal, cette excitation étant de préférence de plusieurs volts avec une fréquence de 100 à 10000 Hertz.

L'excitation induit dans la soupape d'arrêt un champ magnétique alternatif, qui peut être influencé par la position de la tête, le champ magnétique alternatif induisant également un courant dans la seconde bobine. De petites fluctuations de courant dans la seconde bobine sont créées par le déplacement de la tête de la soupape dans le champ magnétique, ces fluctuations pouvant être amplifiées pour détecter le déplacement de cette tête.

Un inconvénient majeur de l'utilisation de bobines pour détecter un déplacement d'une tête de soupape est que le capteur inductif comportant ces bobines doit être de construction simple mais demande un enroulement de très grande dimension afin de produire des amplitudes de tension significatives. Dans certains cas, la bobine doit être enroulée autour de la soupape, ce qui peut être très difficile à mettre en oeuvre dans la plupart des systèmes de test utilisés. Du fait que les exigences en tension et courant pour obtenir une bonne sensibiblité sont très élevées, des amplificateurs de puissance importants et encombrants doivent être prévus. Ainsi, en pratique, le contrôle de soupapes s'avère onéreux et malaisé en raison des dimensions du système.

La présente invention se rapporte à un capteur inductif de déplacement d'une soupape d'arrêt, mis en oeuvre pour détecter le déplacement de la tête de celle-ci, tel que défini dans la revendication 1. Des bobines sont situées sur la surface extérieure de la soupape d'arrêt et positionnées de telle sorte que le déplacement de la tête de celle-ci s'effectue dans les champs magnétiques produits par les bobines. Ces dernières sont connectées par des lignes coaxiales à un circuit de détection.

Si la tête de la soupape passe au travers des champs magnétiques produits par ces bobines, il se produit une variation de tension, détectée par le circuit du capteur, cette variation étant à son tour visualisée par des diodes électroluminescentes (DEL) ou un affichage par de telles diodes, situé dans le circuit de détection. Un enregistreur à bande magnétique est également relié au circuit de détection, de telle sorte que la variation de tension produite soit enregistrée par cet appareil. Le signal pris en compte par l'enregistreur à bande magnétique, peut ensuite être soumis à une analyse par l'opérateur.

Le circuit de détection utilise un oscillateur, comportant un circuit d'excitation pour produire une onde sinusoïdale à fréquence variable, amplifiée par un amplificateur de courant et transmise à un montage en pont. Celui-ci transmet l'onde sinusoïdale vers les bobines extérieures qui, à leur tour, produisent un champ magnétique propre à détecter tout déplacement de la tête de soupape, capté par les bobines et transmis en retour au montage en pont. L'amplificateur de celui-ci fournit une indication de la variation de l'inductance détectée par les bobines à un circuit redresseur et de filtrage.

La sortie subit une certaine amplification dans le circuit redresseur et de filtrage avant d'être transmise à un circuit d'échantillonnage et de maintien à zéro, afin de compenser un décalage initial ou une polarisation du signal. Un circuit de compensation à zéro est également utilisé pour capter le signal. Un circuit de gain et de filtrage final, comportant un amplificateur de filtrage, constitue le dernier étage pour traiter le signal avant que celui-ci ne soit transmis à l'enregistreur à bande magnétique. Un indicateur à diodes électroluminescentes en temps réel visualise les fluctuations du signal.

Les diverses caractéristiques de l'invention sont indiquées en détail dans les revendications annexées à la présente description et font partie de celle-ci. Pour une meilleure compréhension de l'invention, ses avantages fonctionnels ainsi que les buts spécifiques atteints par ses applications, il est fait référence aux dessins annexés et au contenu de cette description, dans lesquels des modes préférés de réalisation de l'invention sont illustrés.

Sur ces dessins :
- La Figure 1 est une vue en perspective d'une soupape d'arrêt, d'un circuit de détection et d'un enregistreur sur bande, conformes à la présente invention ;
- La Figure 2 est une vue en coupe transversale de la soupape d'arrêt de la Figure 1 ;
- La Figure 3 est un affichage du signal enregistré par l'enregistreur sur bande de la Figure 1;
- La Figure 4 est un schéma fonctionnel du circuit de détection de la Figure 1 ;
- La Figure 5 est un schéma fonctionnel d'un oscillateur à onde sinusoïdale du circuit de détection de la Figure 1 ;
- La Figure 6 est un schéma fonctionnel d'un amplificateur de courant du circuit de détection de la Figure 1 ;
- La Figure 7 est un schéma fonctionnel d'un montage en pont utilisé dans le circuit de détection de la Figure 1;
- La Figure 8 est un schéma fonctionnel d'un circuit de redressement et de filtrage du circuit de détection illustré sur la Figure 1 ;
- La Figure 9 est un schéma fonctionnel d'un circuit d'échantillonnage et de maintien du circuit de détection de la Figure 1 ;
- La Figure 10 est un schéma fonctionnel d'un circuit de compensation à zéro du circuit de détection de la Figure 1 ;
- La Figure 11 est un schéma fonctionnel d'un circuit de gain de dernier étage et de filtrage du circuit de détection de la Figure 1 ; et
- La Figure 12 est un schéma fonctionnel d'un circuit indicateur à diodes électroluminescentes du circuit de détection de la Figure 1.

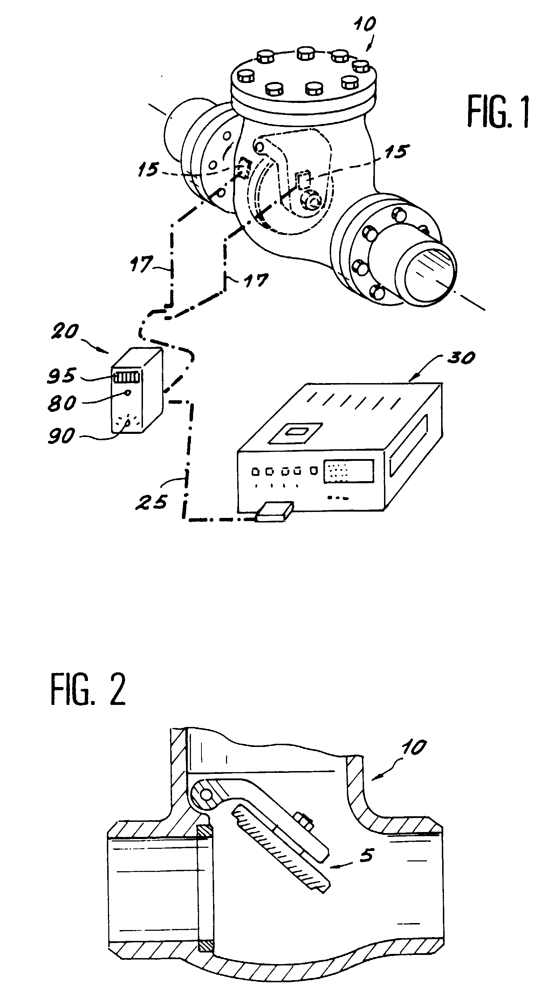

La Figure 1 illustre une soupape d'arrêt, désignée dans son ensemble par 10, comportant des capteurs à bobines 15 placés sur la soupape pour détecter un déplacement de la tête 5 de celle-ci, comme représenté sur la Figure 2. Le déplacement de la tête 5 est réalisé dans le champ magnétique produit par les capteurs à bobines 15. La variation du champ magnétique dans ces bobines, détectée par les capteurs 15, est transmise par des lignes coaxiales 17 à un circuit de détection, globalement désigné par la référence 20. Ce circuit 20 détecte la variation de tension provoquée par la tête 5 et visualise celle-ci sur un afficheur à diodes électroluminescentes 95, tout en introduisant ce signal dans un enregistreur à bande, désigné dans son ensemble par 30, à travers une ligne de transmission des signaux 25, joignant le circuit de détection 20 à cet enregistreur 30.

L'afficheur à diodes électroluminescentes 95 du circuit de détection 20, fournit un signal en temps réel pour un opérateur effectuant un test de déplacement de la tête de la soupape. En enregistrant le signal par l'enregistreur à bande 30, on peut effectuer une analyse ultérieure de ce signal.

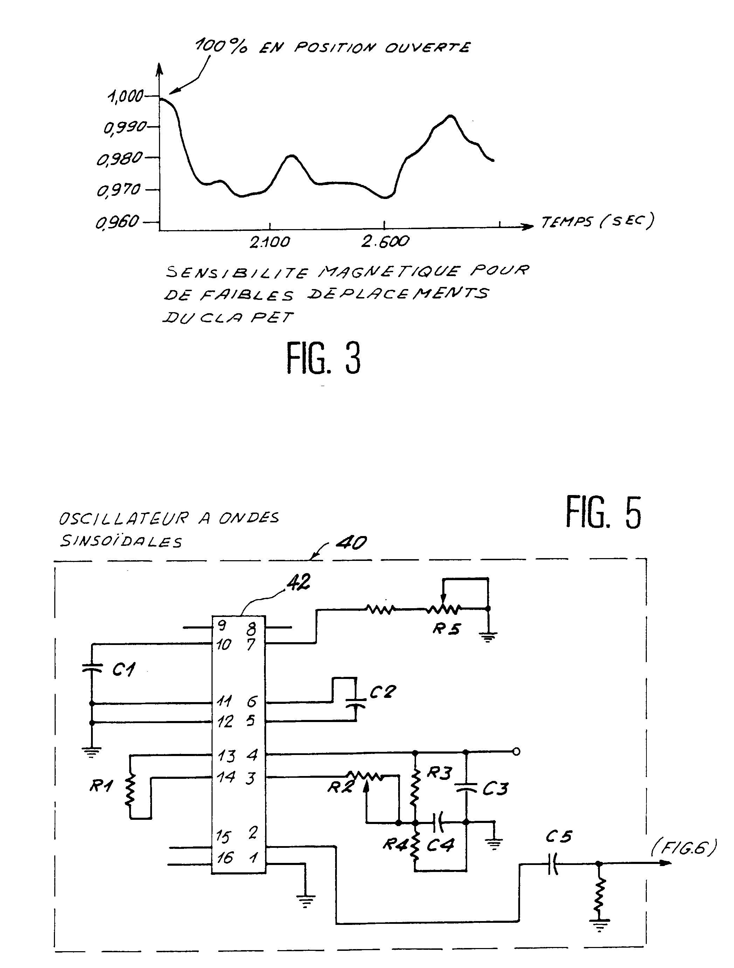

La Figure 3 illustre la forme du signal qui est normalement transmis et enregistré par l'enregistreur à bande 30. L'afficheur à diodes électroluminescentes 95 peut également être un indicateur séparé de la commande de la soupape.

Le capteur inductif de déplacement de la soupape, comportant un montage en pont selon la présente invention, utilise deux petites bobines 15 qui peuvent avoir un rayon effectif de 0,5 à 1,5 pouces (25,4 à 38,1 mm). Ces bobines 15 peuvent être montées dans des boîtiers de protection plats, qui eux-mêmes peuvent adhérer fortement au corps de la soupape 10. Elles peuvent être de forme ovale, de telle sorte que le grand axe de la bobine soit disponible afin d'obliger le champ magnétique à aller plus profondément dans l'enveloppe de la soupape 10. Ces bobines 15 sont enfin positionnées de telle sorte que leurs champs magnétiques peuvent s'étendre dans la zone où la tête 5 de la soupape est assurée de traverser ces champs.

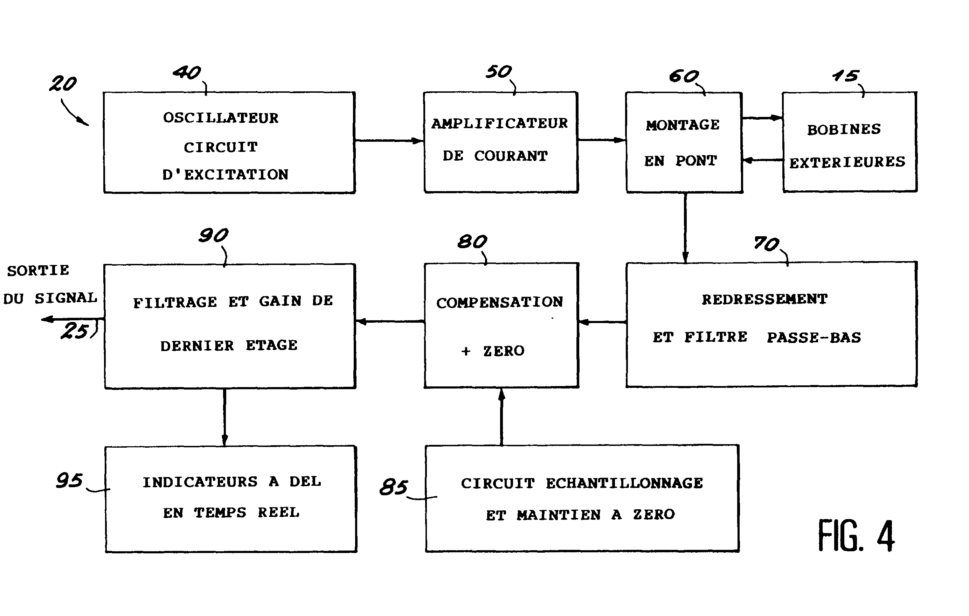

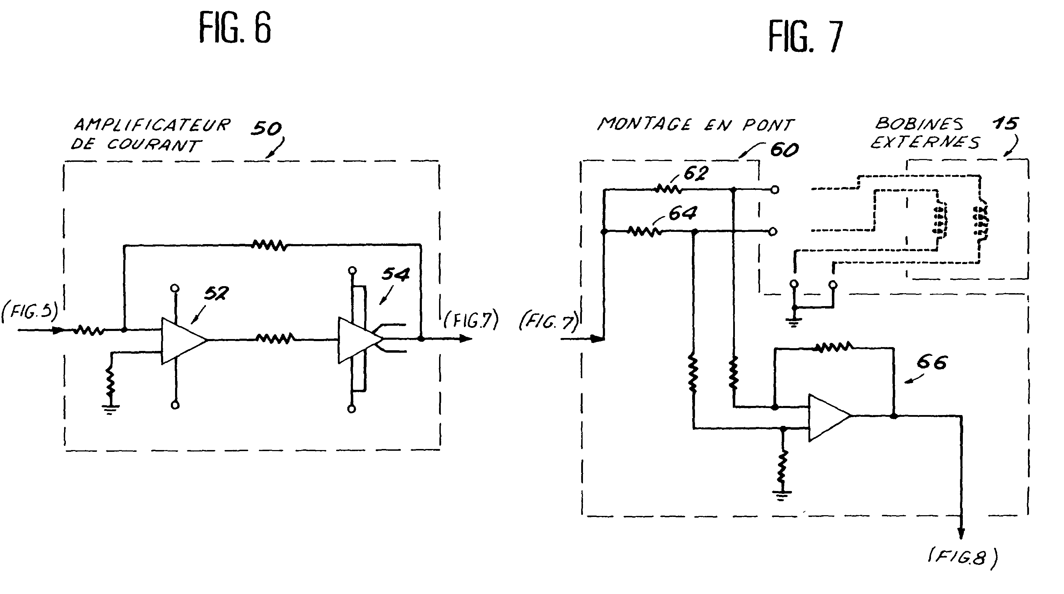

La Figure 4 illustre le circuit de détection 20, comprenant un oscillateur à onde sinusoïdale 40, comme montré à la Figure 5. Cet oscillateur 40 comporte un circuit d'excitation 42, produisant une onde sinusoïdale de fréquence variable qui est régularisée et amplifiée par un amplificateur à courant constant 50.

La Figure 6 montre que l'amplificateur de courant 50 comporte des amplificateurs respectivement 52 et 54, pour amplifier l'onde sinusoïdale et transmettre le signal d'excitation vers un montage en pont 60.

Le signal d'excitation sinusoïdal est transmis, à travers les résistances de chute adaptées 62 et 64 du montage en pont 60 aux bobines extérieures 15, comme montré à la Figure 7. Ces bobines 15 ont approximativement la même résistance et la même inductance, de telle sorte qu'elles forment un montage en pont équilibré, à la sortie 66 du pont. Si ces bobines sont parfaitement équilibrées, la sortie 66 est nulle. Si l'inductance de l'une ou l'autre des bobines varie, la sortie 66 reflètera ces variations.

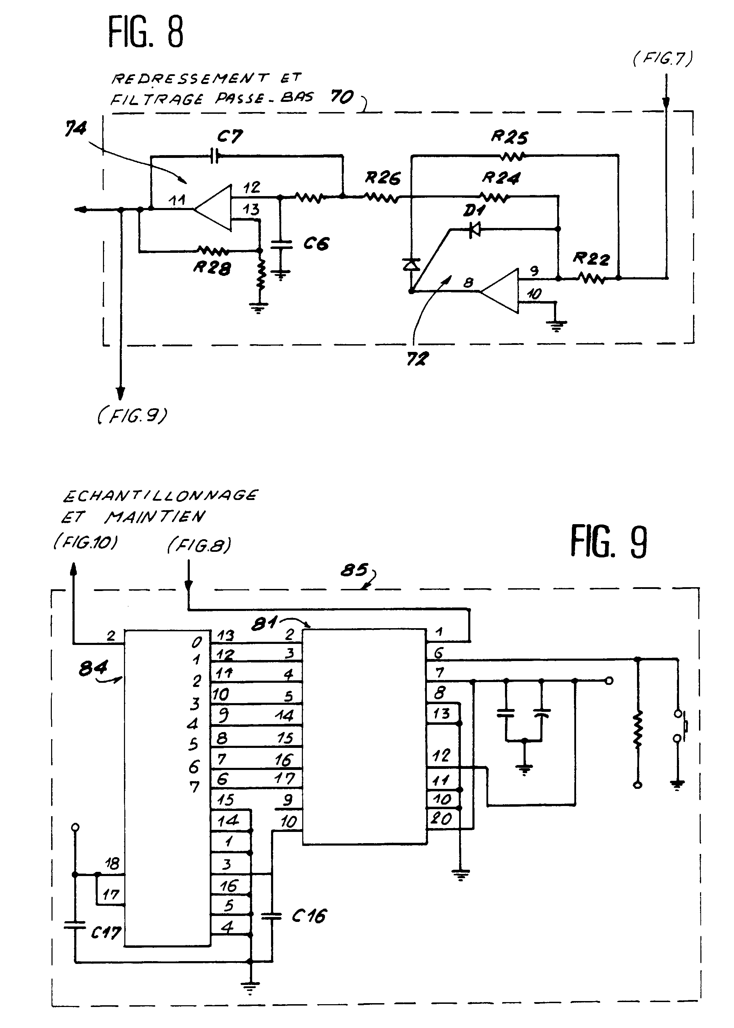

La Figure 8 illustre un circuit de redressement et de filtrage passe-bas 70, qui reçoit la sortie 66 amplifiée par le montage en pont 60. Le signal reçu se dirige vers un circuit redresseur 72, qui amplifie encore le signal et le transmet au circuit de filtrage passe-bas 74, qui soumet également ce signal à une amplification.

La Figure 9 illustre un circuit d'échantillonnage et de maintien à zéro 85, destiné à compenser un certain décalage initial ou une polarisation du signal. Un circuit de prélèvement 87 échantillonne le signal et le transmet à un circuit de maintien 89. L'amplitude du signal peut être captée en tout point particulier dans le temps par un opérateur, actionnant le circuit d'échantillonnage et de maintien à zéro 85 grâce à l'utilisation d'un moyen tel qu'un commutateur instantané.

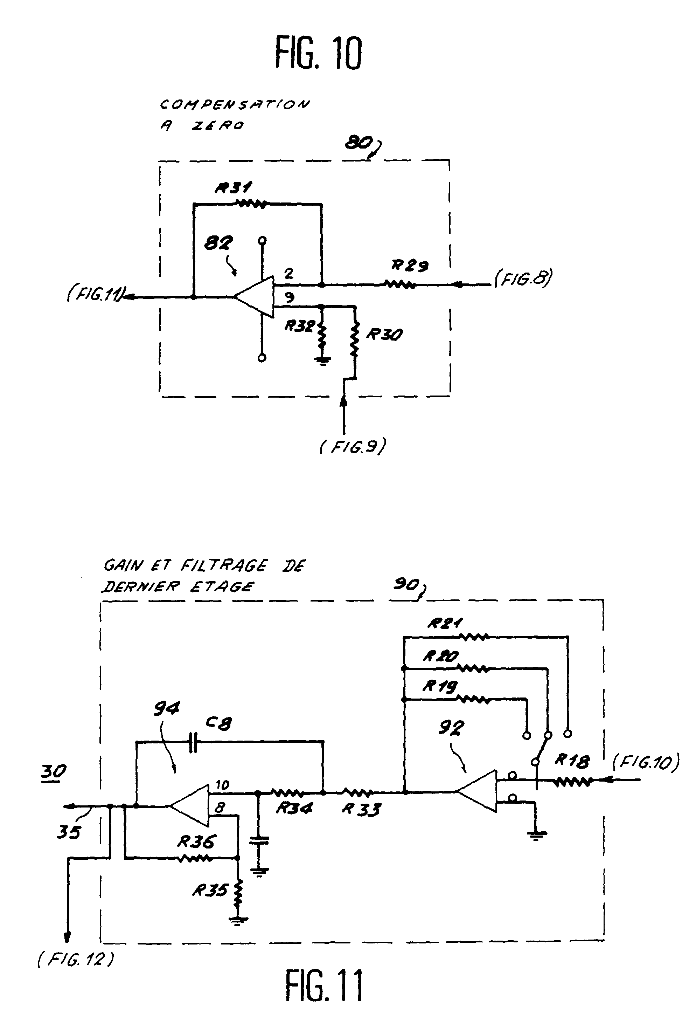

Le signal maintenu dans le circuit d'échantillonnage et de maintien à zéro 85 est transmis à un circuit de compensation à zéro 80, comportant un amplificateur symétrique 82 pour soustraire l'amplitude du signal capté, comme montré sur la Figure 10. Ce signal est ensuite transmis à un circuit de gain et de filtrage final 90, comportant un amplificateur de gain 92 pour une amplification supplémentaire du signal et fournissant un gain variable pour le dernier étage, comme illustré sur la Figure 11. Un amplificateur de filtrage 94 reçoit le signal provenant de l'amplificateur de gain 92 et constitue un dernier étage de filtrage avant que ce signal ne soit envoyé à l'enregistreur à bande 30 à travers la ligne 25.

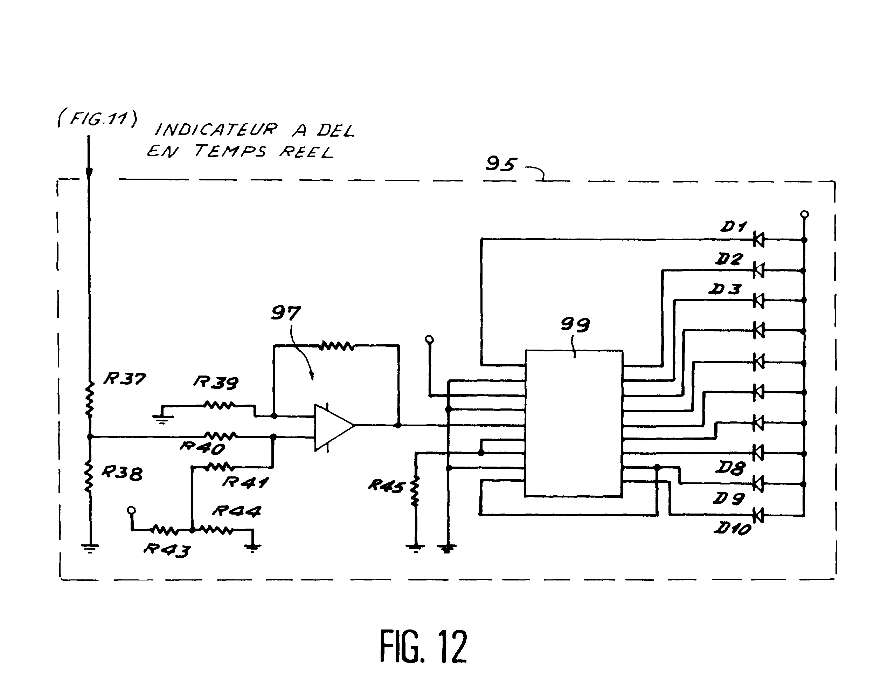

La Figure 12 montre que l'afficheur à diodes électroluminescentes 95 est monté parallèle avec le signal de sortie transmis à l'enregistreur à bande 30 et reçoit également le signal de sortie venant de l'amplificateur de filtrage 94. Celui-ci est amplifié par un amplificateur à diodes électroluminescentes 97 et transmis à une commande d'ensemble 99 pour commander une batterie de telles diodes de façon à obtenir une réaction instantanée aux fluctuations du signal.

L'impédance des bobines 15 varie en fonction de la présence d'un milieu conducteur dans le champ magnétique. Lorsque ce milieu conducteur se déplace à travers le champ magnétique, des courants de Foucault sont créés dans ce milieu. Le matériau conducteur modifie efficacement l'impédance des bobines 15, faisant ainsi varier le signal d'entrée dans le circuit d'équilibrage en pont 60, transmis à partir de ce circuit par la sortie 66. De très petites variations d'impédance des bobines 15 conduisent à des variations significatives transmises par cette sortie 66.

Plusieurs avantages sont obtenus en utilisant les dispositions de la présente invention pour le contrôle de la soupape d'arrêt 10. Un premier avantage est que le circuit inductif en pont 60 permet que de petites bobines 15 soient utilisées, tout en procurant encore de grandes fluctuations d'amplitude de la tension au niveau du circuit de détection 20.

Un second avantage est que de hautes tensions ou de forts courants dans les bobines 15 ne sont pas nécessaires, parce que ces bobines 15 sont disposées selon un agencement en pont équilibré. Cet agencement réduit également les problèmes d'échauffement des bobines et permet d'avoir recours à une électronique légère et compacte pour commander et détecter la réponse des bobines.

Un troisième avantage est que le circuit inductif en pont 60 ne demande pas que la tête 5 de la soupape soit réalisée en un matériau ferromagnétique pour effectuer des contrôles avec succès, comme ce serait requis avec un système magnétique à courant continu, utilisant des capteurs à effet Hall.

Un quatrième avantage est que des fluides conducteurs acoustiques ne sont pas nécessaires pour la soupape 10 afin de transmettre une impulsion à partir de celle-ci vers la tête 5.

Un cinquième avantage est que le circuit de détection 20 est robuste, simple et compact, de telle sorte que ce circuit de détection 20 peut être contenu dans un emballage exploitable sur le terrain.

Un sixième avantage est que l'utilisation de l'enregistreur à bande 30 permet l'enregistrement simultané d'autres données pour des études de corrélation du mouvement de la tête 5 par rapport à d'autres fonctions de la soupape 10.

Un septième avantage est que l'afficheur à diodes électroluminescentes 95 a une réaction en temps réel, de façon à permettre de savoir si un déplacement de la soupape est détecté ou non. Un tel afficheur peut être utilisé pour constituer un système séparé de vérification du mouvement de la soupape.

Un huitième avantage est que le montage en pont 60 permet une variation dans la disposition des bobines 15. Une configuration possible pour ces bobines consiste à en fixer une à la soupape 10 tandis que l'autre est utilisée comme bobine de référence.

Tandis qu'un mode spécifique de réalisation de l'invention a été montré et décrit en détail pour illustrer l'application des principes de l'invention, il sera compris que celle-ci peut être réalisée autrement, sans s'éloigner de ces principes.

## Revendications

1. Dispositif de contrôle inductif pour soupape (10), comportant une tête ou partie mobile (5) située à l'intérieur du corps de la soupape, comprenant :
- au moins une bobine d'induction (15) montée sur une surface extérieure du corps de la soupape pour développer un champ magnétique dans celui-ci, de telle sorte que la partie mobile puisse se déplacer à travers ce champ magnétique ;
- un moyen de détection (20) relié avec la/les bobines d'induction pour détecter un déplacement de la partie mobile à travers les champs magnétiques produits par cette/ces bobines, ce moyen de détection générant un signal de sortie correspondant au mouvement de la partie mobile ;
- un moyen de visualisation (95) connecté au moyen de détection pour visualiser le signal de sortie ;
- et un moyen d'enregistrement (30) également relié avec le moyen de détection pour enregistrer ce signal de sortie ;
- le moyen de détection (20) comprenant un oscillateur (40) pour générer un signal d'excitation transmis à la/aux bobines d'induction (15) afin de produire le champ magnétique ;
caractérisé en ce que le moyen de détection (20) comprend un montage en pont (60) de deux bobines (15) pour détecter une variation du champ magnétique provoquée par le déplacement de la partie mobile (5) à l'intérieur du champ magnétique, ce montage en pont fournissant le signal de sortie correspondant au déplacement de cette partie à l'intérieur du champ magnétique, ce moyen de détection (20) comprenant de plus au moins un amplificateur (50) pour amplifier le signal d'excitation, au moins un amplificateur de gain (92) pour amplifier le signal de sortie et au moins un filtre (70) pour filtrer ce signal de sortie.

2. Dispositif de contrôle selon la revendication 1, caractérisé en ce que le moyen de visualisation est un afficheur à diodes électroluminescentes.

3. Dispositif de contrôle selon la revendication 1, caractérisé en ce que le moyen d'enregistrement (30) est un enregistreur à bande.

## Patentansprüche

1. Induktive Überwachungseinrichtung für ein Ventil (10) mit einer Klappe oder einem beweglichen Teil (5), die oder das innerhalb des Ventilkörpers angebracht ist, mit:
- wenigstens einer Induktionsspule (15), die an einer Außenseite des Ventilkörpers montiert ist, um in diesem ein Magnetfeld derart zu erzeugen, daß das bewegliche Teil sich durch dieses Magnetfeld bewegen kann;
- einem mit der/den Induktionsspule(n) verbundenen Erfassungsmittel zum Erfassen einer Bewegung des beweglichen Teils durch die von der Spule/den Spulen erzeugten Magnetfelder, das ein der Bewegung des beweglichen Teils entsprechendes Ausgangssignal erzeugt;
- einem Anzeigemittel (95), das mit dem Erfassungsmittel verbunden ist, um das Ausgangssignal sichtbar zu machen;
- und einem Aufzeichnungsmittel (30), das ebenfalls mit dem Erfassungsmittel verbunden ist, um dieses Ausgangssignal aufzuzeichnen;
- wobei das Erfassungsmittel (20) einen Oszillator (40) zum Erzeugen eines Erregungssignals umfaßt, das an die Induktionsspule(n) (15) übertragen wird, um das Magnetfeld zu erzeugen;
**dadurch gekennzeichnet**, daß das Erfassungsmittel (20) eine Brückenschaltung (60) von zwei Spulen (15) zum Erfassen einer durch die Bewegung des beweglichen Teils (5) innerhalb des Magnetfelds verursachten Veränderung des Magnetfelds umfaßt, wobei diese Brückenschaltung das der Bewegung des Teils innerhalb des Magnetfelds entsprechende Ausgangssignal liefert, und wobei das Erfassungsmittel (20) außerdem wenigstens einen Verstärker (50) zum Verstärken des Erregungssignals, wenigstens einen Signalverstärker (92) zum Verstärken des Ausgangssignals und wenigstens einen Filter (70) zum Filtern dieses Ausgangssignals umfaßt.

2. Überwachungsvorrichtung nach Anspruch 1, dadurch gekennzeichnet, daß das Anzeigemittel eine Leuchtdiodenanzeige ist.

3. Überwachungsvorrichtung nach Anspruch 1, dadurch gekennzeichnet, daß das Aufzeichnungsmittel (30) eine Bandaufzeichnungsvorrichtung ist.

## Claims

1. A system for inductively inspecting a valve (10) having a moving part or head (5) located within a body of the valve, comprising :
at least one inductive coil (15) mounted to an outer surface of the body of the valve for projecting a magnetic field into the body such that the moving part can move through the magnetic field ;
sensing means (20) communicating with the inductive coil(s) for detecting movement of the moving part through the magnetic fields produced by this/these coils, said sensing means generating an output signal corresponding to the movement of the moving part ;
display means (95) connected to the sensing means for displaying the output signal ; and
recording means (30) also connected to the sensing means for recording said output signal, the sensing means (20) including an oscillator (40) for generating an excitation signal, which is provided to the inductive coil(s) (15) for producing the magnetic field, characterized in that the sensing means (20) further includes a bridge circuit (60) with two coils (15) for detecting a change in the magnetic field caused by the movement of the moving part (5) within the magnetic field, said bridge circuit providing the output signal corresponding to the movement of said part within the magnetic field, the sensing means (20) further includes at least one amplifier (50) for amplifying the excitation signal, at least one gain amplifier (92) for amplifying the output signal and at least one filter (70) for filtering said output signal.

2. The system according to Claim 1, characterized in that display means is a light emitting diode display.

3. The system according to Claim 1, characterized in that the recording means (30) is a tape recorder.
